# EUROPEAN PATENT SPECIFICATION

(11) **EP 3 168 877 B1**
(45) Date of publication and mention of the grant of the patent: **22.06.2022**
(21) Application number: 15425096.3
(22) Date of filing: 13.11.2015
(51) Int. Cl.: H01L 27/30, H01L 51/42

(54) **A WIRE SHAPED COAXIAL PHOTOVOLTAIC SOLAR CELL**
DRAHTFÖRMIGE KOAXIALE PHOTOVOLTAISCHE SOLARZELLE
CELLULE SOLAIRE PHOTOVOLTAÏQUE COAXIALE SOUS FORME DE CÂBLE

(43) Date of publication of application: 17.05.2017
(73) Proprietor: SCEYE Inc, Moriarty NM 87035 (US); Bonar N.V., 9240 Zele (BE); CENTITVC Centre for Nanotechnology and Smart Materials, 4760-034 V.N. Famalicao (PT)
(72) Inventor: Caputo, Giuseppe, I-10125 Torino (IT); Chabrecek, Peter, 9325 Roggwil (CH); Balakrishnan, Muralidharan, 9430 St.Margrethen (CH); Lantus, Muriel, 07200 Aubenas (FR); Dalsgaard, Christian, 8260 Viby J. (DK); Al-Tal, Ibrahim, 8210 Aarhus V. (DK); Fyson, John, London, E9 7AS (GB); Harrison, David, Uxbridge, Middlesex UB8 3PH (GB); Canart, Virginie, 4020 Liège (BE); Heyse, Pieter, 9800 Deinze (BE); Paquet, Bernard, 4700 Eupen (BE); Parrein, Tim, B-9240 Zele (BE); Swennen, Ives, B-9240 Zele (BE); Van den Storme, Guy, B-9700 Oudenaarde (BE); Van den Storme, Manuel, B- 9681 Etikhove (BE); Lindstrand, Per, Oswestry (GB); Barnfield, Lee, Oswestry (GB); Blanco, Dani, 36 - 08302 Mataró (ES); Carlos, Pérez, 36 -08302 Mataró (ES); Nazeeruddin, Mohammad Khaja, CH-1024 Ecublens (CH); DAR, Mohammad Ibrahim, 191111 Budgam / Kashmir, J&K (IN); Graetzel, Michael, CH-1025 Saint-Sulpice (CH); Little, Philip, Old Buckenham, Attleborough NR17 1RX (GB); Jones, Ian Anthony, Great Abington, Cambridge CB21 6AL (GB); Durand, Geraldine, Great Abington, Cambridge CB21 6AL (GB); Durães, Nelson Manuel Feio, 4730-360 Pedregais VVD (PT); Gomes, João Manuel Carvalho, 4700-832 Braga (PT); Cardoso, Nelson Duarte da Silva, 4445-310 Ermesinde (PT); Caldeira Pinto, André Lourenço, 4970-744 Arcos de Valdevez (PT); Poças Gonçalves, José Joaquim, 4710-436 Braga (PT); Marques, Antonio Fernando California, 4710-089 Braga (PT)
(74) Representative: De Tullio, Michele Elio

(56) References cited:
- WO-A1-93/20569
- LONGBIN QIU ET AL: "Integrating Perovskite Solar Cells into a Flexible Fiber", ANGEWANDTE CHEMIE INTERNATIONAL EDITION, vol. 53, no. 39, 22 September 2014 (2014-09-22), pages 10425-10428, XP55271834, DE ISSN: 1433-7851, DOI: 10.1002/anie.201404973

## Description

### FIELD OF THE INVENTION

The invention relates to a coaxially wire shaped photovoltaic solid state solar cell (PSC) with an heterojunction comprising a perovskite material and a surface-increasing nanostructured semiconductor. The invention also relates to the method and the apparatus for the fabrication of said wire shaped PSC.

### BACKGROUND OF THE INVENTION

Dye sensitized solar cells (DSCs) and solid state heterojunction solar cells show promising photovoltaic performance. Such devices have still to face several problems, which prevent them from achieving higher efficiencies, such as stability, low open circuit voltage and recombination issues. Said solar cells can't be efficiently be weaved and integrated in a textile to fabricate photovoltaic textiles.

In addition it is very difficult to obtain efficient wire shaped solar cells capable to be weaved and integrated in a textile to fabricate photovoltaic textiles.

Wire shaped photovoltaic cells are already known in the art, but known wire shaped solar cell technologies are based on DSCs technology which makes use of organometallic or organic dyes in conjunction with liquid or quasi-liquid electrolytes which dramatically lower long term stability and makes very difficult their manufacturing process.

In recent years, wire-based DSCs have been reported for example in Fan et al. (Adv. Mater., 20, 592-595, 2008]. Wire-based DSCs have advantages such as lightweight and cost-effectiveness. However, the conversion efficiency (η) of these devices are lower compared with planar DSCs because the dye molecules are not allowed to absorb enough light through the electrolyte which has strong absorption at visible-light region.

In the patent application WO2014045021A1 is disclosed an optoelectronic devices having a thin film of a light-absorbing or light-emitting perovskite disposed between n-type (electron conducting) and p-type (hole conducting) layers.

In the patent application EP2693503A1 a solid-state solar cell with a solid state heterojunction is claimed, comprising a conducting support layer, on which a surface-increasing scaffold structure is provided, wherein an organic-inorganic perovskite layer is provided on said scaffold structure.

In said prior art documents no wire shaped solid state heterojunction solar cells has been described.

The patent application CN104009105A describes an invention based on the preparation of a linear electrode of transparent carbon nanometer tube plate perovskite CH₃NH₃PbI₃ solar cell. This flexible braided coaxial linear perovskite solar cell comprises an electrode of stainless steel wire coated with a layer of nanotitanium dioxide particles, an active layer material of perovskite, a hole transport layer material and a final wrapping transparent carbon nanometer tube plate as another electrode. It is said that compared with the traditional planar structure of the solar battery, the claimed linear perovskite solar battery can be conveniently woven into fabric or other structure.

Another prior art document, the patent application WO93/20569, discloses a photovoltaic coaxial cell, comprising: a cylindrical conductive element - in the form of a textile conductive filament or a wire such as copper wire - on to which one or more titanium dioxide layers have been applied; a solid electrolyte that has been applied concentrically around said cylindrical conductive element; and/or a light transmitting electrically conductive polymer, through which light can pass to the TiO2 layer, that has been applied concentrically around the cylindrical component. The process described in said patent application refers to a coaxial photovoltaic DSC (classical Graetzel cell) employing molecular dyes (ruthenium dyes) and electrolytes.

In the state of the art it is well known the disadvantages of wire or fiber shaped devices comprising liquid electrolytes, such as the problem of solvent evaporation and the penetration of water into the solar cell caused by difficulty in long-term stability and cell sealing especially in temperature cyclic tests.

It is also well known the disadvantages of devices comprising expensive organic hole conductor materials, also known as hole transport materials (HTM), such as the incomplete pore filling which is observed with such hole conductors. Said hole conductor tends not to penetrate equally through the mesoporous film of sensitized solar cells using a porous semiconductor anode.

Furthermore, in the state of the art it is still to be addressed the problem of oxidization of the hole conductor. Oxidation of the hole conductor may cause stability problems and lack of consistency.

Furthermore, the present invention addresses the problem of low hole mobility observed with conductors used in the prior art, which are low compared to liquid electrolytes.

The solar cell according to the present invention differs from previously known wire shaped solar cells because advantageously avoids the use of electrolytes.

The invention provides an efficient wire shaped solar cell that can be prepared rapidly in an efficient way, using readily available, low-cost materials, using a short manufacturing procedure based on industrially known manufacturing steps.

The present invention addresses the problems of stability observed with certain dye-sensitized solar cells.

The present invention also addresses the advantage in manufacturing weavable photovoltaic devices by means of using photovoltaic fibers.

### SUMMARY OF THE INVENTION

The present invention provides a novel wire shaped coaxial solid state photovoltaic solar cell comprising several coaxial layers around a core conducting wire. The present invention provides also methods for the fabrication of said wire shaped coaxial solid state photovoltaic solar cell by means of a coaxially deposition of several layers around a core conducting wire. The invention also relates to apparatus for the fabrication of said wire shaped solar cell.

In an aspect, the present invention provides a solid-state solar cell comprising at least a conducting wire and a surface-increasing nanostructured semiconductor scaffold layer deposited on the outer surface of the wire, wherein one or more organic-inorganic perovskite layer is provided on said scaffold layer and wherein a counter electrode and/or metal layer is provided in electric contact with said perovskite layer without any hole transport material.

In another aspect, the present invention provides a solid-state solar cell comprising at least a conducting wire and a surface-increasing nanostructured semiconductor scaffold layer deposited on the outer surface of the wire, wherein one or more organic-inorganic perovskite layer is provided on said scaffold layer and wherein a counter electrode and/or metal layer is provided in electric contact with said perovskite layer, said solid-state solar cell comprising a cheap hole transport material.

The present invention addresses the advantage of avoiding the use of expensive organic HTM by means of an inorganic salt type hole conductor that is selected from the group of effective and cheap inorganic p-type hole-transporting material on perovskite-based devices. According to one embodiment said p-type hole-transporting material is an inorganic copper thiocyanate or an inorganic copper thiosulfate salt, diluted in a proper solvent.

The coaxial solid state solar cell described in this invention has the following advantages over the dye-sensitized solar cells kwown in the state of the art:
- usable for realizing a photovoltaic fiber;
- a higher efficiency than a standard dye-sensitized solar cell;
- a higher flexibility and the need of less raw material;
- an easier fabrication and the absence of leakage, due to no use of liquid electrolyte;
- a wider solar spectrum available for conversion.

In another aspect, the present invention provides a method for the fabrication of a coaxial solid state solar cell without any hole transport material, said method comprising at least the steps of:
- providing a conducting support layer on which a surface-increasing nanostructured semiconductor scaffold layer is deposited;
- applying one or more organic-inorganic perovskite layer on said scaffold structure; and,
- applying a counter electrode.

In another aspect, the present invention provides a method of preparing a solid state solar cell, said method comprising at least the steps of:
- providing a conducting support layer on which a surface-increasing nanostructured semiconductor scaffold layer is deposited;
- applying one or more organic-inorganic perovskite layer on said scaffold structure;
- applying one copper thiocyanate layer on perovskite structure; and,
- applying a counter electrode.

In another aspect the present invention includes an apparatus to perform a method according to any one or more of the compatible method embodiments described above, comprising: inner conductor unwinding servo feeder; different kind of curing means for the deposition processes and coating; winder servo tension control; control means, to control or regulate temperature and/or pressure and/or flow rate and/or other process parameters.

In another aspect, the present invention provides an apparatus for the production of a wire shaped coaxial photovoltaic solar cell that comprising the following steps:
- pretreatment of conductive metallic wire shaped support with air temperature;
- treatment of the conductive metallic wire shaped support;
- deposition of a TiO2 nanostructured semiconductor scaffold layer and curing by IR radiation or heat treatment;
- deposition of one or more solid state perovskite layers;
- deposition of a counter electrode layer;
- deposition of a protective layer.

In another aspect, the present invention provides an apparatus for the fabrication of a wire shaped coaxial photovoltaic solar cell that performs the following steps:
- pretreatment of conductive metallic wire shaped support with air temperature;
- treatment of the conductive metallic wire shaped support;
- deposition of a TiO2 nanostructured semiconductor scaffold layer and curing by IR radiation or heat treatment;
- deposition of one or more solid state perovskite layers;
- deposition of an inorganic hole transport layer
- deposition of a counter electrode layer;
- deposition of a protective layer.

Further aspects and preferred embodiments of the invention are defined herein below and in the appended claims. Further features and advantages of the invention will become apparent to the skilled person from the description of the preferred embodiments given below.

### BRIEF DESCRIPTIONS OF THE FIGURES

Figure 1 provides a schematic circular section of the wire shaped photovoltaic solar cell according to one embodiment of the present invention.
Figure 2 shows a block diagram of the process for the preparation of a wire shaped coaxial solar cell.
Figure 3 shows a schematic view of the incorporation step of nanoparticles in the outer conductor layer of the wire shaped photovoltaic solar cell.
Figure 4 shows a schematic view of a first apparatus for a continuous process for a wire shaped coaxial solar cell.
Figure 5 shows a schematic view of a second apparatus for a continuous process for a wire shaped coaxial solar cell.

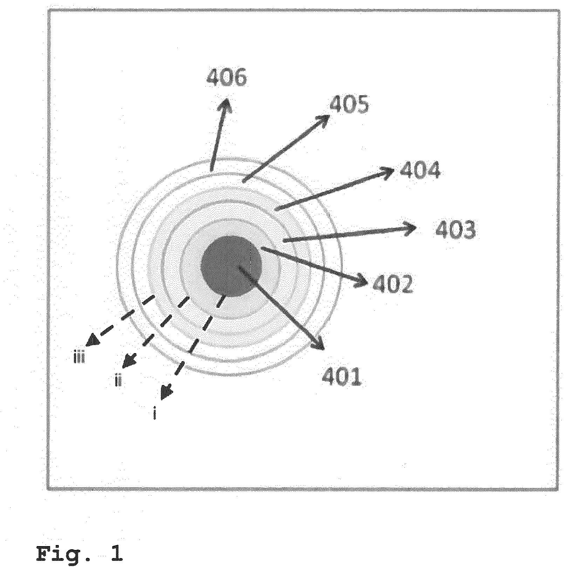

Figures 1-5 are to be regarded as being purely exemplary and intended to illustrate the text, and not to limit the scope of the invention.

### DETAILED DESCRIPTION OF THE INVENTION

The present invention relates to a coaxially wire shaped photovoltaic solid state solar cell with an heterojunction comprising a perovskite material and a surface-increasing nanostructured semiconductor scaffold. The invention also relates to the methods for the fabrication of said solar cell and to the apparatus for the fabrication of said solar cell by means of applying said methods.

According to an embodiment of the invention, the heterojunction comprises one or more layers of organic-inorganic perovskite, wherein said layers may each be the same or different.

As used in the present invention the term "perovskite", refers to the "perovskite structure" and not specifically to the perovskite material, CaTiO3. For the purpose of this specification, "perovskite" describes any material that has the same type of crystal structure as calcium titanium oxide and of materials in which the bivalent cation is replaced by two separate monovalent cations. The perovskite structure has the general stoichiometry AMX3, where "A" and "M" are cations and "X" is an anion. The "A" and "M" cations can have a variety of charges and in the original Perovskite mineral (CaTiO3), the A cation is divalent and the M cation is tetravalent.

For the purpose of this invention, the perovskite formulae includes structures having 3 or 4 anions, which may be the same or different, and/or one or two organic cations, and/or metal atoms carrying two or three positive charges.

Typically organic-inorganic perovskites are hybrid materials exhibiting combined properties of organic composites and inorganic crystalline. The inorganic component forms a framework bound by covalent and ionic interactions which provide high carrier mobility. The organic component helps in the self-assembly process of these materials, it also enables the hybrid materials to be deposited by low-cost technique as other organic materials.

In the present invention the perovskite is used in the form of one or more layers, said layers are organic-inorganic perovskite compounds of formula (I) :

[A,B]_{1,2}[M,N] [X]_{3,4} (I)

wherein:
- A is a monovalent organic cation, in the form of A or A₂;
- B is a bivalent organic cation;
- M is a metal atom;
- N is a metal atom;
- X is an anionic compound, in the form of X₃ or X₄.

Preferably, A and B are selected from hydrocarbons comprising up to 15 carbons, and from 1 to 20 heteroatoms (for A) and 2 to 20 heteroatoms (for B), in particular one or two positively charged nitrogen atoms, respectively, besides possibly further heteroatoms selected from N, O and S. Furthermore, A and B may be partially or totally halogenated, independently of said 1 to 20 heteroatoms.

M is a metal atom, which may be selected from the group consisting of Cu, Ni, Co, Fe2+, Mn2+, Cr2+, Pd2+, Cd2+, Ge2+, Sn2+, Pb2+, Eu2+, or Yb2+. Preferably, M is Sn2+ or Pb2+. N is a trivalent metal, which is preferably selected from the group of Bi3+ and Sb3+.

X is an anionic compound, and is preferably selected independently from CI-, Br-, I-, NCS-, CN-, NCO-, and combinations thereof. As there may be three X in formulae (I), the perovskite material may comprise combinations of different halogens. For example, "X3" may be selected from I2Cl-3, I2Br-3, Cl2I-3, Br2I-3.

The four anions in "X4" may also be a combination of different halogens. Preferably, X is Br- or I-.

Not exhaustive examples of surface-increasing nanostructured semiconductor scaffold comprise Si, TiO2, SnO2, Fe2O3, ZnO, WO3, Nb2O5, CdS, ZnS, PbS, Bi2S3, CdSe, CdTe, SrTiO3, GaP, InP, GaAs, CuInS2, CuInSe2, and combinations thereof. Preferred semiconductor materials are Si, TiO2, SnO2, ZnO, WO3, Nb2O5 and SrTiO3.

Not exhaustive examples of conducting wire shaped supports comprise Cu, Mo, Ti, Ni and W wires.

Figure 1 shows a transversal circular section of a preferred embodiment of the invention that preferentially comprises the following layers deposited coaxially around a core conductive wire:
- a conductive wire shaped support and/or charge collector (401);
- a nanostructured semiconductor scaffold layer (402);
- a perovskite layer (403);
- an optional hole transporting materials layer (404);
- a counter electrode or outer conductor(405)
- an outer protective layer (406);

Said wire shaped solar cell is a solid state dye solar cell, where a perovskite dye in the perovskite layer (403) is used instead of the standard electrolytic dye. The perovskite acts at the same time as a dye and as a dielectric.

In a further preferred embodiment the wire shaped solar cell comprises the following layers deposited coaxially around a conductive wire:
- a conductive wire shaped support and/or charge collector (401);
- an additional primer layer (i);
- a nanostructured semiconductor scaffold layer (402);
- an additional protective layer (ii);
- one or more perovskite layers (403);
- an additional protective layer (iii);
- a counter electrode or outer conductor layer (405);
- an outer protective layer (406).

In a further preferred embodiment the wire shaped solar cell comprises the following layers deposited coaxially around a conductive wire:
- a conductive wire shaped support and/or charge collector (401);
- an additional primer layer (i);
- a nanostructured semiconductor scaffold layer (402);
- an additional protective layer (ii);
- one or more perovskite layers (403);
- an inorganic hole conducting material layer (404);
- an additional protective layer (iii);
- a counter electrode or outer conductor layer (405);
- an outer protective layer (406).

Said conductive wire shaped support and/or charge collector (401) is a metallic wire selected from the group consisting of Cu, Mo, Ti, Ni and W.

Said inorganic hole conducting material layer (404) is preferentially consisting of copper thiocyanate.

In a preferred embodiment said nanostructured semiconductor scaffold layer (402) is a titanium dioxide layer. Optimum efficiency is obtained with a TiO2 layer of 0.5um.

Said counter electrode (405), also known as outer conductor, is a transparent conductive coating (TCC) applied directly on the top of the photovoltaic material. This enables a constant electrical conductivity on the fibre surface area.

In a preferred embodiment of the invention nanoparticles are directly deposited on the active perovskite layer (403), wherein such deposition is preferentially made by means of a laser cure. Said nanoparticles are selected from the group consisting of Indium Tin Oxide (ITO), Antimony Tin Oxide (ATO), Cu nanoparticles, Ag nanoparticles.

In another preferred embodiment said nanoparticles are preferentially incorporated in a matrix comprised in the outer conductor (405). Said matrix is a polymeric matrix selected from the group consisting of acrylate matrix and epoxy matrix. The epoxy matrix is characterized by low curing temperature. The acrylate matrix is characterized by UV curing condition. The nanoparticles incorporated in the matrix of the outer conductor (405) are selected from the group consisting of Indium Tin Oxide (ITO), Antimony Tin Oxide (ATO), Cu nanoparticles, Ag nanoparticles.

In order to incorporate large quantity of nanoparticles in the outer conductor (405), such as up to 80% wt, the surface of said nanoparticles has to be modified (functionalization) by one or more chemical groups. Such one or more chemical groups react with the host matrix, if the host matrix is used. In a preferred embodiment said nanoparticles are functionalized using a reactant selected from the group consisting of epoxy silane, acrylate silane, mercapto silsesquioxane ligant (POSS).

The outer protective layer (406) protects the electrically active layers of the wire shaped solar cell from shorting to any local electrical conductors and from any wear to adjacent surfaces. Said protective layer protects the overall photovoltaic layers from moisture and oxygen and give an electrical isolation. Furthermore this layer (406) gives to the invention the suitable properties for weaving (abrasion resistance, electrical resistance, high mechanical integrity, easy extrudability). In a preferred embodiment said protective layer (406) is highly transparent and is preferentially an acrylate based coating.

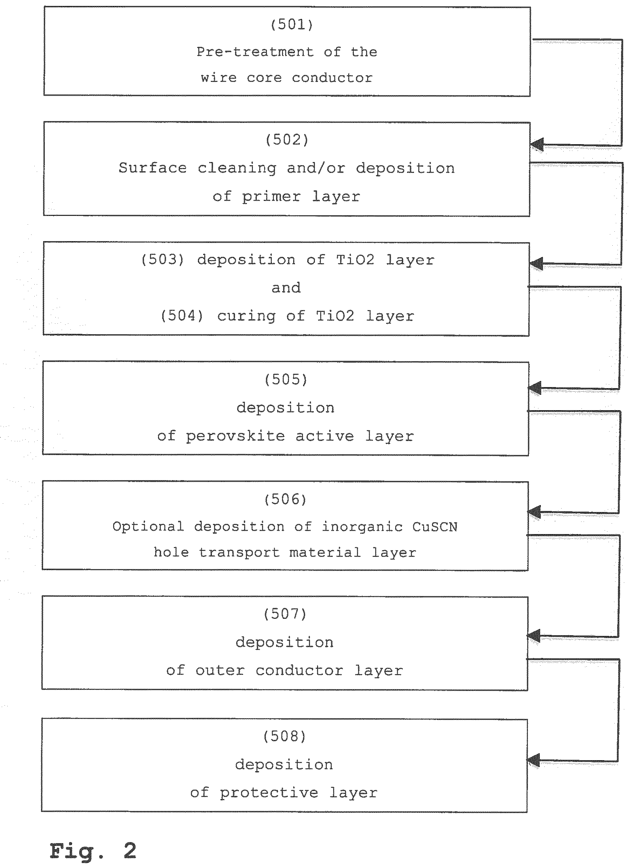

Figure 2 shows the block diagram of a process for the fabrication of a wire shaped solar cell described in the present invention. Said block diagram comprises the following steps:
- (501) pre-treatment of the wire core conductor. Said core conductor is preferentially a metallic conductor selected from the group of metals consisting of: titanium, copper, molybdenum, tungsten, nickel. Specifications of said pretreatment are defined also taking into account the fiber performance and the requirements for interconnections, knitting and weaving properties.
- (502) cleaning the surface of the wire core conductor and/or depositing a primer layer, using at least one of the method selected from the group consisting of:
   a)UV-ozone cleaning;
   b)TiCl4 pre-treatment;
   c)sintering conducted at temperatures not higher than 500°C
- (503) deposition of a titanium dioxide layer on the wire core conductor, using at least one of the method selected from the group consisting of:
   ▪ a Chemical Bath Deposition (CBD) followed by an Atomic Layer Deposition(ALD);
   ▪ a TiO2 colloid dip coating followed by (ALD);
   ▪ a TiO2 diluted paste dip coating;
   ▪ a TiO2 diluted paste pultrusion coating;
   ▪ TiO2 Paste dip coating using wire pre-heat or TiCl4 primer as adhesion promoter;
   ▪ TiO2 growing from TiCl4 water based solution;
   ▪ TiO2 growing from TiCl4 sintering;
   ▪ Functionalization of TiO2 with Silane;
   ▪ Low temperature deposition;
   ▪ ALD deposition.
- (504) curing said titanium dioxide layer either by application of infrared radiation or by heat treatment.
- (505) deposition of a perovskite layer through wire dip coating or wire pultrusion coating using at least one of the method selected from the group consisting of:
   a) one step deposition process, preferably from a solution containing lead iodide, methylammonium iodide and dimethylformamide;
   b) two steps deposition process where the first step uses a solution containing lead iodide and dimethylformamide; and the second step uses a solution containing methylammonium iodide and Isopropanol. This is a faster deposition in order to not dissolve the previous lead iodide layer.
- (506) deposition of an optional inorganic CuSCN hole transport material layer.
- (507) deposition of the outer conductor layer (406) using a Transparent Conductive Oxide (TCO) alone or, alternatively, with a TCO followed by a second wire metallic core coated with platinum.
- (508) deposition of the outer protective coating using polymeric materials applied with dipping or pultruding technique and curing by heat or infrared, and UV.

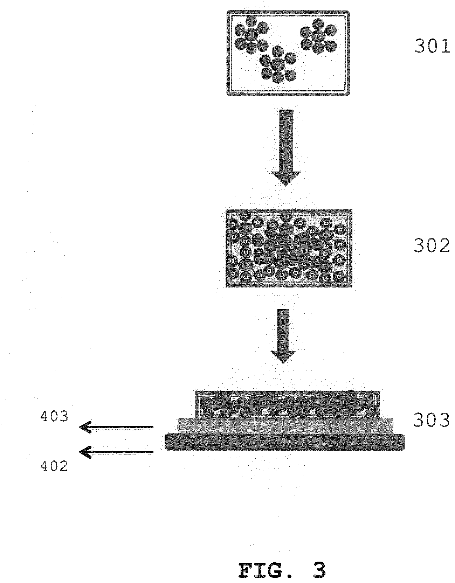

Figure 3 shows a schematic view of the incorporation step of nanoparticles in the outer conductor layer (405) applied in a preferred embodiment. In a first step (301) the surface of the nanoparticles are functionalized by one or more chemical groups in the presence of a solvent characterized by high viscosity. Said solvent is selected from a group consisting of (1) a mix of Ethylene glycol (EG) and diethylene glycol monobutyl ether (DGME), (2) butyl acetate (BAc). Said solvent allows the nanoparticles to stay in suspension while functionalization is carried out. In a second step (302) the functionalized nanoparticles react with the host matrix through interaction with the chemical groups present on the nanoparticles surface. In a third step a thin film deposition is obtained over the active photovoltaic layer (403) using either dip coating or bar coating. A final curing method is required, dependent of the choice of the matrix. For an epoxy system, a temperature cure is used. For an acrylate system, the functional group present in the system permit a UV cure.
A laser is used in order to fuse the nanoparticles into a film when no matrix is present.

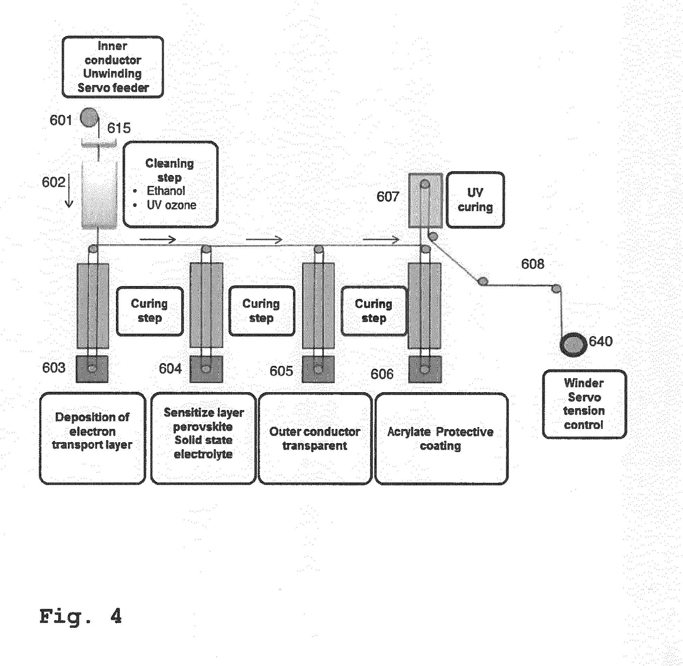

Figure 4 is an exemplary schematic diagram of an apparatus to perform a method according to any one or more of the compatible method embodiments described above, comprising:
- inner conductor unwinding servo feeder (601);
- conductive wire core material (615);
- means for performing cleaning step (602);
- means for performing deposition of electron transport layer and curing step (603);
- means for performing deposition of perovskite layer and curing step (604);
- means for performing deposition of the outer conductor layer and curing step (605);
- means for performing deposition of acrylate protective coating and curing step (606);
- means for performing UV curing (607);
- coaxially wire shaped photovoltaic solid state solar cell (608);
- winder servo tension control.

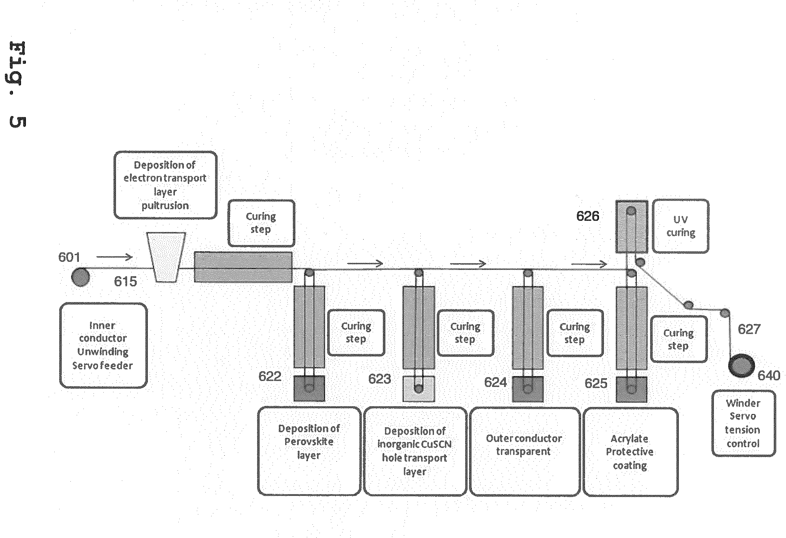

Figure 5 is an exemplary schematic diagram of an apparatus to perform a method according to any one or more of the compatible method embodiments described above, comprising:
- inner conductor unwinding servo feeder (601);
- conductive wire core material (615);
- means for performing deposition of electron transport layer by means of pultrusion and following curing step (621);
- means for performing deposition of perovskite layer and curing step (622);
- means for performing deposition of inorganic hole transport material layer and curing step (623);
- means for performing deposition of the outer conductor layer and curing step (624);
- means for performing deposition of acrylate protective coating and curing step (625);
- means for performing UV curing (626);
- coaxially wire shaped photovoltaic solid state solar cell (627);
- winder servo tension control (640).

For the scope of the present invention the above described apparatus, performing a method according to any one or more of the compatible method embodiments described above, takes advantage also by the use of
- a device to ensure the wire is centered to the nozzle when entering it so that the wire is coated evenly, and
- a device on which the nozzle size can be easily adapted to the diameter of the wire to that the deposited layer is even and smooth.

### EXAMPLES

### Experimental procedure for preparation of wire core conductor

In a preferred embodiment the wire core conductor is pre-treated in order to increase its performance in the final wire shaped coaxial solar cell. Said pre-treatment is preferably conducted at temperature not higher than 500°C, in the presence of an inert atmosphere or, alternatively, using a mixture of reactive gases.

The metallic wires of the core conductor is selected from the group consisting of:
1. Titanium wire (Ti), with diameter comprised between 40 µm and 100 µm, preferentially 80µm;
2. Copper wire (Cu), with diameter comprised between 40 µm and 100 µm, preferentially 50 µm;
3. Molybdenum wire (Mo), with diameter comprised between 40 µm and 100 µm, preferentially 40 µm;
4. Tungsten wire (W), with diameter comprised between 40 µm and 100 µm, preferentially 70 µm;
5. Nickel wire (Ni), with diameter comprised between 40 µm and 100 µm, preferentially 80 µm.

### Experimental procedure for preparation of the TiO2 scaffold layer

In a preferred embodiment a titanium dioxide layer is deposited on the core wire by dip coating or pultrusion coating to form a layer having a thickness between 50 and 500 nm, preferentially 150 nm.

A commercially available TiO2 diluted paste "Ti-Nanoxide T-L" from Solaronix is used to perform the coating. This paste allows a further curing at lower temperature compared to usual TiO2 formulations.

A curing step is performed either by infrared or heat treatment. This curing step is required to evaporate the solvent from the TiO2 diluted paste. Heat or IR are set-up to provide a temperature comprised between 90 and 250°C to avoid oxidation on the core material.

### Experimental procedure for preparation of the solid state perovskite layer

In a preferred embodiment the 40 wt.% CH3NH3PbI3 precursor solution is prepared by reacting PbI2 (Aldrich, 98%) and as-prepared CH3NH3I powders with 1:1 molar ratio in the appropriate solvent.

The HTM is deposited by dip coating or pultrusion coating at the speed of 1 to 3m/min. The HTM solution is prepared by dissolving copper thiocyanate (Sigma Aldrich) in propyl sulphide (Sigma Aldrich) at 6mg/mL.

Some preferred realization of Perovskite devices based on synthesized semiconductors have been prepared and tested. Photovoltaic properties are summarized in a table below.

**Table 1**

| **ID** | **E**_{**S**/S+}, **V** | **J**_{**SC**,} **mA/cm²** | **V_{OC}**, **mV** | **FF** | **η**, % |
|---|---|---|---|---|---|
| KR54 | 0.4 | 15.615 | 792 | 0.49 | 6.19 |
| KR56 | 0.935 | 4.649 | 772 | 0.34 | 1.26 |
| KR60 | 0.84 | | | | |
| KR73 | 0.8 | 15.776 | 618 | 0.59 | 5.79 |
| KR90 | 0.905 | | | | |
| KR120 | 0.325 | 11.562 | 780 | 0.32 | 2.91 |

### Experimental procedure for preparation of an outer protective coating

Coating the protective layer (acrylates) by dip coating or pultrusion and curing the acrylate at 85°C to evaporate the solvent followed by UV curing (1 min at 2-3 J/cm²).

### Experimental results of PV fibre/yarn based on one preferred embodiment of the invention

In one preferred embodiment, the active surface area of the PV fibre is 1.256 cm2 for 1m length. It corresponds to 1.75 mW/m of fibre and a current of 2.2 mA/m.

**Table 2: Electrical specifications of PV fibre/yarn**

| **Specification** | **Value** | **Test Method** | **Priority** |
|---|---|---|---|
| Power generation Pₒᵤₜ | >1.5 mW/m (12W/m2) | Under 1 sun irradiation, for 150um Ø diam. (active surface: ½ fibre surface) | 1 |
| Voltage Uₚₘₐₓ | > 600mV | | 1 |
| Electrical current Iₚₘₐₓ | > 4 mA/m | | 1 |
| Fill factor | > 0.5 | | 2 |

## Claims

1. A wire shaped coaxial photovoltaic solar cell comprising:
- a conductive core wire shaped support (401),
- a nanostructured semiconductor scaffold layer (402),
- one or more successive perovskite layers (403),
- an optionally provided hole transporting material layer (404),
- an outer conductor layer (405),
- an outer protective layer (406),
**characterized in that** said outer conductor layer (405) comprises dispersed nanoparticles and said perovskite layers (403) are composed identically or wherein two or more of said perovskite layers have a different molecular structure and/or composition.

2. The wire shaped coaxial photovoltaic solar cell according to claim 1 comprising:
- an additional primer layer (i), positioned between the conductive core wire shaped support (401) and the nanostructured semiconductor scaffold layer (402),
- an additional protective layer (ii), positioned between the nanostructured semiconductor scaffold layer (402) and the perovskite layers (403),
- an additional protective layer (iii), positioned between the perovskite layers (403) and the outer conductor layer (405).

3. The wire shaped coaxial photovoltaic solar cell according to any one of the preceding claims wherein the conductive core wire is a metallic wire selected from the group consisting of Cu, Mo, Ti, Ni, W, and wherein said wire has a diameter comprised between 40 µm and 100 µm.

4. The wire shaped coaxial photovoltaic solar cell according to claim 1 wherein nanoparticles of the outer conductor layer (405) are dispersed in a polymeric matrix, preferably said matrix is acrylate matrix or epoxy matrix, said nanoparticles are selected from the group consisting of indium tin oxide, antimony tin oxide, copper nanoparticles, silver nanoparticles, and their related mixtures.

5. The wire shaped coaxial photovoltaic solar cell according to claim 4 wherein said dispersed nanoparticles are functionalized with chemical groups selected from epoxy silane, acrylate silane, or their mixtures, said functionalization increasing dispersion and stability of nanoparticles in the polymeric matrix, permitting loading of nanoparticles up to 80% wt.

6. The wire shaped coaxial photovoltaic solar cell according to claims 1, 2, 4 and 5 wherein the outer conductor (405) is a thin film of nanoparticles, said nanoparticles selected from the group consisting of indium tin oxide, antimony tin oxide, copper nanoparticles, silver nanoparticles, and their related mixtures.

7. The wire shaped coaxial photovoltaic solar cell according to claim 6 wherein the nanoparticles of the thin film are nanoparticles functionalized with silsesquioxane ligand.

8. The wire shaped coaxial photovoltaic solar cell according to any one of the preceding claims 1-7 where the outer protective layer (406) is a polymeric coating, preferably an acrylate based coating.

9. The wire shaped coaxial photovoltaic solar cell according to any one of the preceding claims 1-8 where the nanostructured semiconductor scaffold layer (402) is a titanium dioxide nanostructured semiconductor scaffold layer.

10. The wire shaped coaxial photovoltaic solar cell according to any one of the preceding claims 1-9 wherein the hole transporting material layer (404) is an inorganic copper thiocyanate or an inorganic copper thiosulfate salt, diluted in a solvent.

11. A method for the fabrication of a wire shaped coaxial photovoltaic solar cell as in claim 1 and 2, the method comprises the following steps:
- pretreatment of a conductive metallic wire shaped support (501),
- cleaning the surface of the wire core conductor and/or depositing a primer layer (502),
- deposition of a titanium dioxide layer on the wire core conductor (503),
- curing said titanium dioxide layer either by application of infrared radiation or by heat treatment (504),
- deposition of a perovskite layer (505) through wire dip coating or wire pultrusion coating using at least one of the method selected from the group consisting of:
a) one step deposition process, preferably from a solution containing lead iodide, methylammonium iodide and dimethylformamide;
b) two steps deposition process, where the first step uses a solution containing lead iodide and dimethylformamide and the second step uses a solution containing methylammonium iodide and isopropanol,
- deposition of an optional inorganic hole transport material layer (506),
- deposition of an outer conductor layer (507),
- deposition of the outer protective coating (508) .

12. The method according to claim 11 wherein the cleaning step and/or depositing step (502) is preferentially performed using at least one of the method selected from the group consisting of:
a)UV-ozone cleaning,
b)TiCl4 pre-treatment,
c)sintering conducted at temperatures not higher than 500°C.

13. The method according to claim 11 wherein the deposition step (503) of a titanium dioxide layer is preferentially performed using at least one of the method selected from the group consisting of:
- chemical bath deposition followed by an atomic layer deposition,
- TiO2 colloid dip coating followed by atomic layer deposition,
- TiO2 diluted paste dip coating,
- TiO2 diluted paste pultrusion coating,
- TiO2 paste dip coating using wire pre-heat or TiCl4 primer as adhesion promoter,
- TiO2 growing from TiCl4 water based solution,
- TiO2 growing from TiCl4 sintering,
- functionalization of TiO2 with silane,
- low temperature deposition,
- atomic layer deposition.

14. The method according to claim 11 wherein the deposition step (508) of the outer protective coating is preferentially performed using a polymeric materials applied with dipping or pultruding technique and curing by heat or infrared, and UV.

15. An apparatus for the production of a wire shaped coaxial photovoltaic solar cell that performs the steps according to claim 11.

## Patentansprüche

1. Eine drahtförmige koaxiale photovoltaische Solarzelle, umfassend:
- einen leitfähigen kerndrahtförmigen Träger (401),
- eine nanostrukturierte Halbleitergerüstschicht (402),
- eine oder mehrere aufeinanderfolgende Perowskitschichten (403),
- eine optional bereitgestellte Lochtransportmaterialschicht (404),
- eine äußere Leiterschicht (405),
- eine äußere Schutzschicht (406),
**dadurch gekennzeichnet, dass** die äußere Leiterschicht (405) dispergierte Nanopartikel umfasst und die Perowskitschichten (403) identisch zusammengesetzt sind oder zwei oder mehr der Perowskitschichten eine unterschiedliche molekulare Struktur und/oder Zusammensetzung aufweisen.

2. Drahtförmige koaxiale photovoltaische Solarzelle nach Anspruch 1, umfassend:
- eine zusätzliche Grundierungsschicht (i), die zwischen dem leitfähigen kerndrahtförmigen Träger (401) und der nanostrukturierten Halbleitergerüstschicht (402) positioniert ist,
- eine zusätzliche Schutzschicht (ii), die zwischen der nanostrukturierten Halbleitergerüstschicht (402) und den Perowskitschichten (403) positioniert ist,
- eine zusätzliche Schutzschicht (iii), die zwischen den Perowskitschichten (403) und der äußeren Leiterschicht (405) positioniert ist.

3. Drahtförmige koaxiale photovoltaische Solarzelle nach einem der vorhergehenden Ansprüche, wobei der leitfähige Kerndraht ein Metalldraht ist, ausgewählt aus der Gruppe bestehend aus Cu, Mo, Ti, Ni, W, und wobei der Draht einen Durchmesser zwischen 40 µm und 100 µm aufweist.

4. Drahtförmige koaxiale photovoltaische Solarzelle nach Anspruch 1, wobei Nanopartikel der äußeren Leiterschicht (405) in einer Polymermatrix dispergiert sind, vorzugsweise ist die Matrix eine Acrylatmatrix oder Epoxidmatrix, wobei die Nanopartikel ausgewählt sind aus der Gruppe bestehend aus Indiumzinnoxid , Antimon-Zinn-Oxid, Kupfer-Nanopartikel, Silber-Nanopartikel und ihre verwandten Mischungen.

5. Drahtförmige koaxiale photovoltaische Solarzelle nach Anspruch 4, wobei die dispergierten Nanopartikel mit chemischen Gruppen, ausgewählt aus Epoxysilan, Acrylatsilan oder deren Mischungen, funktionalisiert sind, wobei die Funktionalisierung die Dispersion und Stabilität von Nanopartikeln in der Polymermatrix erhöht und die Beladung von Nanopartikeln bis 80 Gew.-% ermöglicht.

6. Drahtförmige koaxiale photovoltaische Solarzelle nach den Ansprüchen 1, 2, 4 und 5, wobei der äußere Leiter (405) ein Dünnfilm aus Nanopartikeln ist, wobei die Nanopartikel ausgewählt sind aus der Gruppe bestehend aus Indium-Zinn-Oxid, Antimon-Zinn-Oxid, Kupfer-Nanopartikeln, Silbernanopartikel und ihre verwandten Mischungen.

7. Drahtförmige koaxiale photovoltaische Solarzelle nach Anspruch 6, wobei die Nanopartikel des Dünnfilms mit Silsesquioxan-Liganden funktionalisierte Nanopartikel sind.

8. Drahtförmige koaxiale photovoltaische Solarzelle nach einem der vorhergehenden Ansprüche 1-7, wobei die äußere Schutzschicht (406) eine Polymerbeschichtung ist, vorzugsweise eine Beschichtung auf Acrylatbasis.

9. Drahtförmige koaxiale photovoltaische Solarzelle nach einem der vorhergehenden Ansprüche 1 bis 8, wobei die nanostrukturierte Halbleitergerüstschicht (402) eine nanostrukturierte Halbleitergerüstschicht aus Titandioxid ist.

10. Drahtförmige koaxiale photovoltaische Solarzelle nach einem der vorhergehenden Ansprüche 1 bis 9, wobei die Lochtransportmaterialschicht (404) ein anorganisches Kupferthiocyanat oder ein anorganisches Kupferthiosulfatsalz ist, dass in einem Lösungsmittel verdünnt ist.

11. Verfahren zur Herstellung einer drahtförmigen koaxialen Photovoltaik-Solarzelle nach Anspruch 1 und 2, wobei das Verfahren die folgenden Schritte umfasst:
- Vorbehandlung eines leitfähigen metallischen drahtförmigen Trägers (501),
- Reinigung der Oberfläche des Drahtkernleiters und/oder Aufbringen einer Grundierungsschicht (502),
- Aufbringen einer Titandioxidschicht auf dem Drahtkernleiter (503),
- Härten der Titandioxidschicht entweder durch Anwendung von Infrarotstrahlung oder durch Wärmebehandlung (505),
- Aufbringen einer Perowskitschicht (505) durch Drahttauchbeschichtung oder Draht-Pultrusionsbeschichtung unter Verwendung von mindestens einem der Verfahren ausgewählt aus der Gruppe bestehend aus:
a) einstufiges Ablagerungsverfahren, vorzugsweise aus einer Bleijodid, Methylammoniumjodid und Dimethylformamid enthaltenden Lösung;
b) zweistufiges Ablagerungsverfahren, wobei im ersten Schritt eine Bleijodid und Dimethylformamid enthaltende Lösung und im zweiten Schritt eine Methylammoniumjodid und Isopropanol enthaltende Lösung verwendet wird,
- Aufbringen einer optionalen anorganischen Lochtransportmaterialschicht (506),
- Aufbringen einer äußeren Leiterschicht (507),
- Aufbringen der äußeren Schutzbeschichtung (508).

12. Verfahren nach Anspruch 11, wobei der Reinigungsschritt und/oder der Schritt des Aufbringens (502) vorzugsweise ausgeführt wird unter Verwendung von mindestens einem der Verfahren, ausgewählt aus der Gruppe bestehend aus:
a) UV-Ozon-Reinigung,
b) TiCl4 Vorbehandlung,
c) Sintern, durchgeführt bei Temperaturen von nicht mehr als 500°C.

13. Verfahren nach Anspruch 11, wobei der Aufbringungsschritt (503) einer Titandioxidschicht vorzugsweise unter Verwendung von mindestens einem der Verfahren durchgeführt wird, ausgewählt aus der Gruppe bestehend aus:
- chemische Badabscheidung gefolgt von einer Atomlagenabscheidung,
- TiO2-Kolloid-Tauchbeschichtung gefolgt von Atomlagenabscheidung,
- TiO2 verdünnte Pastentauchbeschichtung,
- TiO2 verdünnte Pasten-Pultrusionsbeschichtung,
- TiO2-Pasten-Tauchbeschichtung mit Drahtvorwärmung oder TiCI4 Grundierungsschicht als Haftvermittler,
- TiO2 Wachstum aus einer TiCl4-Lösung auf Wasserbasis,
- TiO2 Wachstum aus TiCl4 Sinterung,
- Funktionalisierung von TiO2 mit Silan,
- Niedertemperaturabscheidung,
- Atomlagenabscheidung.

14. Verfahren nach Anspruch 11, wobei der Aufbringungsschritt (508) der äußeren Schutzbeschichtung vorzugsweise unter Verwendung eines Polymermaterials durchgeführt wird, das mit Tauch- oder Pultrusionstechnik aufgebracht wird und durch Wärme oder Infrarot und UV gehärtet wird.

15. Vorrichtung zur Herstellung einer drahtförmigen koaxialen photovoltaischen Solarzelle, die die Schritte nach Anspruch 11 durchführt.

## Revendications

1. Cellule solaire photovoltaïque coaxiale en forme de fil comprenant:
- un support en forme de fil d'âme conducteur (401),
- une couche d'échafaudage semi-conducteur nanostructurée (402),
- une ou plusieurs couches successives de pérovskite (403),
- une couche de matériau de transport de trous (404), éventuellement prévue,
- une couche conductrice externe (405),
- une couche de protection externe (406),
**caractérisée en ce que** ladite couche conductrice externe (405) comprend des nanoparticules dispersées et lesdites couches de pérovskite (403) sont composées de manière identique ou dans lequel deux ou plusieurs desdites couches de pérovskite ont une structure moléculaire et/ou une composition différente.

2. Cellule solaire photovoltaïque coaxiale en forme de fil selon la revendication 1, comprenant:
- une couche d'apprêt supplémentaire (i), positionnée entre le support en forme de fil d'âme conducteur (401) et la couche d'échafaudage semi-conductrice nanostructurée (402),
- une couche de protection supplémentaire (ii), positionnée entre la couche d'échafaudage semi-conductrice nanostructurée (402) et les couches de pérovskite (403),
- une couche de protection supplémentaire (iii), positionnée entre les couches de pérovskite (403) et la couche conductrice externe (405).

3. Cellule solaire photovoltaïque coaxiale en forme de fil selon l'une quelconque des revendications précédentes, dans laquelle le fil d'âme conducteur est un fil métallique choisi dans le groupe constitué de Cu, Mo, Ti, Ni, W, et dans laquelle ledit fil a un diamètre compris entre 40 µm et 100 µm.

4. Cellule solaire photovoltaïque coaxiale en forme de fil selon la revendication 1, dans laquelle les nanoparticules de la couche conductrice externe (405) sont dispersées dans une matrice polymère, de préférence ladite matrice est une matrice acrylate ou une matrice époxy, lesdites nanoparticules sont choisies dans le groupe constitué d'oxyde d'indium et d'étain, l'oxyde d'antimoine et d'étain, les nanoparticules de cuivre, les nanoparticules d'argent et leurs mélanges associés.

5. Cellule solaire photovoltaïque coaxiale en forme de fil selon la revendication 4, dans laquelle lesdites nanoparticules dispersées sont fonctionnalisées avec des groupes chimiques choisis parmi l'époxy silane, l'acrylate silane ou leurs mélanges, ladite fonctionnalisation augmentant la dispersion et la stabilité des nanoparticules dans la matrice polymère, permettant le chargement des nanoparticules jusqu'à 80% en poids.

6. Cellule solaire photovoltaïque coaxiale en forme de fil selon les revendications 1, 2, 4 et 5, dans laquelle le conducteur extérieur (405) est un film mince de nanoparticules, lesdites nanoparticules étant choisies dans le groupe constitué d'oxyde d'indium-étain, d'oxyde d'antimoine-étain, de nanoparticules de cuivre, de nanoparticules d'argent et leurs mélanges associés.

7. Cellule solaire photovoltaïque coaxiale en forme de fil selon la revendication 6, dans laquelle les nanoparticules du film mince sont des nanoparticules fonctionnalisées avec un ligand silsesquioxane.

8. Cellule solaire photovoltaïque coaxiale en forme de fil selon l'une quelconque des revendications précédentes 1 à 7, dans laquelle la couche protectrice externe (406) est un revêtement polymère, de préférence un revêtement à base d'acrylate.

9. Cellule solaire photovoltaïque coaxiale en forme de fil selon l'une quelconque des revendications 1 à 8 précédentes, dans laquelle la couche d'échafaudage semi-conductrice nanostructurée (402) est une couche d'échafaudage semi-conductrice nanostructurée en dioxyde de titane.

10. Cellule solaire photovoltaïque coaxiale en forme de fil selon l'une quelconque des revendications précédentes 1 à 9, dans laquelle la couche de matériau de transport de trous (404) est un thiocyanate de cuivre inorganique ou un sel de thiosulfate de cuivre inorganique, dilué dans un solvant.

11. Procédé de fabrication d'une cellule solaire photovoltaïque coaxiale en forme de fil selon les revendications 1 et 2, le procédé comprenant les étapes suivantes :
- prétraitement d'un support en forme de fil métallique conducteur (501),
- nettoyage de la surface de l'âme du fil conducteur et/ou déposition d'une couche d'apprêt (502),
- dépôt d'une couche de dioxyde de titane sur l'âme du fil conducteur (503),
- traitement de ladite couche de dioxyde de titane soit par application d'un rayonnement infrarouge soit par traitement thermique (504),
- dépôt d'une couche de pérovskite (505) par revêtement par immersion de fil ou revêtement par pultrusion de fil en utilisant au moins un procédé choisi parmi le groupe formé par:
a) processus de dépôt en une étape, de préférence d'une solution contenant iodure de plomb, iodure de méthyl-ammonium, et diméthyl-formamide
b) processus de dépôt en deux étapes, dans lequel la première étape utilise une solution contenant iodure de plomb et diméthyl-formamide, et la deuxième étape utilise une solution contenant iodure de méthyl-ammonium et isopropanol,
- dépôt d'une couche inorganique facultative de matériau de transport de trous inorganique (506),
- dépôt d'une couche conductrice externe (507),
- dépôt du revêtement protecteur extérieur (508).

12. Procédé selon la revendication 11, dans lequel l'étape de nettoyage et/ou l'étape de dépôt (502) sont préférentiellement exécutées en utilisant au moins l'un des procédés choisis dans le groupe consistant en:
a) nettoyage UV d'ozone,
b) prétraitement de TiCl4,
c) frittage effectué à des températures ne dépassant pas 500°C.

13. Procédé selon la revendication 11, dans lequel l'étape de dépôt (503) d'une couche de dioxyde de titane est préférentiellement réalisée en utilisant au moins l'un des procédés choisis dans le groupe constitué de:
- dépôt en bain chimique suivi d'un dépôt en couche atomique,
- revêtement par immersion de colloïde de TiO2 suivi d'un dépôt de couche atomique,
- revêtement par immersion de pâte diluée de TiO2,
- revêtement par pultrusion de pâte diluée de TiO2,
- revêtement par immersion de pâte de TiO2 utilisant un préchauffage du fil ou un apprêt de TiCl4 comme promoteur d'adhérence,
- TiO2 croissant à partir d'une solution aqueuse de TiCl4,
- TiO2 croissant du frittage de TiCl4,
- fonctionnalisation du TiO2 avec du silane,
- dépôt à basse température,
- dépôt de couche atomique.

14. Procédé selon la revendication 11, dans lequel l'étape de dépôt (508) du revêtement protecteur externe est préférentiellement réalisée en utilisant des matériaux polymères appliqués avec une technique d'immersion ou de pultrusion et de traitement par chaleur ou infrarouge, et UV.

15. Appareil pour la production d'une cellule solaire photovoltaïque coaxiale en forme de fil qui exécute les étapes selon la revendication 11.
